# EUROPEAN PATENT APPLICATION

(11) **EP 4 819 201 A1**
(43) Date of publication of application: **07.10.2026**
(21) Application number: 24897601.1
(22) Date of filing: 27.11.2024
(51) Int. Cl.: H01L 21/60, C22C 21/00, C22C 21/02, C22F 1/00, C22F 1/04

(54) **AL BONDING WIRE OR AL BONDING RIBBON**

(30) Priority: 27.11.2023 WO PCT/JP2023/042366; 27.11.2023 WO PCT/JP2023/042369; 27.11.2023 WO PCT/JP2023/042371; 27.11.2023 WO PCT/JP2023/042373; 27.11.2023 WO PCT/JP2023/042374; 04.06.2024 WO PCT/JP2024/020313; 04.06.2024 WO PCT/JP2024/020314
(71) Applicant: NIPPON STEEL CHEMICAL & MATERIAL CO., LTD., Tokyo 103-0027 (JP); Nippon Micrometal Corporation, Iruma-shi Saitama 358-0032 (JP)
(72) Inventor: UNO, Tomohiro, Tokyo 100-8071 (JP); TAKAYAMA, Toru, Tokyo 100-8071 (JP); ODA, Daizo, Iruma-shi, Saitama 358-0032 (JP); ETO, Motoki, Iruma-shi, Saitama 358-0032 (JP)
(74) Representative: Grünecker Patent- und Rechtsanwälte PartG mbB
(86) International application number: PCT/JP2024/042022
(87) International publication number: WO 2025/115917

(57) **Abstract**

To provide an Al bonding wire or an Al bonding ribbon that exhibits excellent rapid temperature cycle reliability even in a rapid temperature cycle test in which an upper limit temperature is high, which is required for next-generation SiC power semiconductors. The Al bonding wire or the Al bonding ribbon contains 3.0% by mass or more and 20.0% by mass or less of Si, wherein a closed curve representing an outer periphery of a cross section in a direction perpendicular to a center axis of the Al bonding wire or the Al bonding ribbon is defined as S₀, a closed curve having a similar shape scaled by 2/3 with respect to S₀ is defined as S₁, and a closed curve having a similar shape scaled by 1/3 with respect to S₀ is defined as S₂, and S₀, S₁, and S₂ are arranged such that centroids thereof coincide with a centroid of the cross section in a direction perpendicular to the center axis of the Al bonding wire or the Al bonding ribbon, and a region surrounded by S₀ and S₁ is defined as a surface part and a region surrounded by S₂ is defined as a core part, and when a volume fraction of voids having an equivalent sphere diameter equal to or larger than 1 um and smaller than 10 µm in the core part measured by X-ray CT analysis is defined as Rd and a volume fraction of voids having an equivalent sphere diameter equal to or larger than 1 µm and smaller than 10 µm in the surface part is defined as Rf, a ratio (Rf/Rd) is equal to or larger than 0.005 and equal to or smaller than 0.50.

## Description

### TECHNICAL FIELD

The present invention relates to an Al bonding wire or an Al bonding ribbon. The present invention further relates to a semiconductor device obtained by using the Al bonding wire or the Al bonding ribbon.

### BACKGROUND ART

In a semiconductor device, electrodes formed on a semiconductor chip are connected with a lead frame or electrodes on a substrate via a bonding wire (wire material) or a bonding ribbon (bar material). In a power semiconductor device, used is a bonding wire or a bonding ribbon made mainly of aluminum (Al) as a material. A wire diameter of the Al bonding wire mainly falls within a range from 100 µm to 600 µm. A width of the Al bonding ribbon mainly falls within a range from 100 µm to 3000 µm, and a thickness thereof falls within a range from 50 µm to 600 µm. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al bonding wire or the Al bonding ribbon are often used as large power equipment such as air conditioners and photovoltaic power generation systems, or as vehicle-mounted semiconductor devices.

A bonding method for the Al bonding wire or the Al bonding ribbon includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al bonding wire or the Al bonding ribbon via a jig (tool) made of metal, breaking surface oxide films of the Al bonding wire or the Al bonding ribbon and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire or the Al bonding ribbon, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al bonding wire or the Al bonding ribbon and the semiconductor chip, is repeatedly applied to the 1st bonding part. In a case of using a connection material made only of high-purity Al, the Al bonding wire or the Al bonding ribbon is broken in a relatively short time due to thermal stress, so that it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide (Mg₂Si).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 µm. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

### RELATED ART REFERENCEPatent Literature

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

### SUMMARY OF INVENTIONPROBLEM TO BE SOLVED BY THE INVENTION

As described above, the next-generation power semiconductor device is required to withstand a longer-time use as compared with a general-purpose power semiconductor device. The temperature of the 1st bonding part repeatedly rises and falls at the time when the power semiconductor device operates. As a result, because the Al bonding wire or the Al bonding ribbon has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al bonding wire or the Al bonding ribbon. A temperature cycle test is one of the tests for evaluating, in an accelerated manner, a lifetime of wire (or ribbon) bond accompanying a temperature rise and a temperature fall of the 1st bonding part (temperature cycle reliability). The Al bonding wire or the Al bonding ribbon used for the next-generation power semiconductor is required to exhibit excellent temperature cycle reliability in the temperature cycle test.

However, in a case of using the Al bonding wire that is highly strengthened by adding Si and the like thereto as disclosed in Patent Literatures 1 to 3, the present inventors have confirmed that there is a problem in that a crack develops at a relatively high speed in an Al alloy electrode having lower strength than that of the Al bonding wire in a temperature cycle test assuming a use in the next-generation power semiconductor device, and favorable temperature cycle reliability is difficult to be stably obtained.

On the other hand, a conventional temperature cycle test (hereinafter, also referred to as "TCT (Temperature Cycle Test)") can be easily performed by using a commercially available testing apparatus. However, a changing speed of a temperature in the TCT is relatively slow, so that there is concern about a deviation from a fast temperature changing speed at the time when the power semiconductor device operates. Thus, recently, a rapid temperature cycle test (hereinafter, also referred to as a "rapid TCT"), in which the temperature changing speed is increased, has been examined to be brought closer to a condition of real use. The changing speed of the temperature is, for example, about 10°C/min in the conventional TCT, while the temperature changes at high speed such as about 200°C/min in the rapid TCT, for example. The present inventors have confirmed that, regarding evaluation of reliability of a bonding part of the Al bonding wire or the Al bonding ribbon, even with the Al bonding wire or the Al bonding ribbon the reliability of which is not lowered when it is evaluated by the conventional TCT, bonding strength may be lowered and a lifetime of wire (or ribbon) bond may be shortened when it is evaluated by the rapid TCT. Thus, there is a demand for an Al bonding wire or an Al bonding ribbon that exhibits favorable reliability of the bonding part and excellent temperature cycle reliability even in the rapid TCT that is a more rigorous test close to the condition of real use. Hereinafter, the temperature cycle reliability in the rapid TCT may be referred to as "rapid temperature cycle reliability".

In next-generation power semiconductor elements that replace silicon (Si), which has been mainstream, use of silicon carbide (SiC) having high heat resistance is predicted to advance. In a connection for a SiC power semiconductor, a rapid temperature cycle test that is more severe than a current temperature cycle test is required. For example, while a temperature range of a rapid temperature cycle test for a Si semiconductor is -40°C to 150°C, rapid temperature cycle reliability in a range from -40°C to 175°C as a severe temperature condition is required for a SiC semiconductor. Furthermore, as a requirement for a next-generation SiC power semiconductor that is used at high output by utilizing heat resistance of SiC, it is required to exhibit excellent rapid temperature cycle reliability even under a more severe test condition in which an upper limit temperature increases to 185°C. Herein, when the upper limit temperature of the rapid TCT increases from 175°C to 185°C, a temperature difference of a heat cycle increases by 10°C, and the above-described difference in thermal expansion at the bonding part of the Al bonding wire or the Al bonding ribbon is increased, so that there is a problem in that fatigue breakdown is accelerated. Furthermore, since a high temperature is reached, a bonding state of the bonding interface before the test becomes a cause that promotes fatigue breakdown, so that it is necessary to improve the bonding state at an initial stage.

The present invention has been made in view of the above problem, and aims at providing an Al bonding wire or an Al bonding ribbon that exhibits excellent rapid temperature cycle reliability even in a rapid temperature cycle test in which an upper limit temperature is high, which is required for next-generation SiC power semiconductors.

### MEANS FOR SOLVING PROBLEM

As a result of earnest investigation as to the problem described above, the present inventors have found that, in an Al bonding wire or an Al bonding ribbon containing 3.0% by mass or more and 20.0% by mass or less of Si, when a volume fraction of voids having an equivalent sphere diameter equal to or larger than 1 µm and smaller than 10 µm in a core part measured by X-ray Computed Topograpy (CT) analysis is defined as Rd and a volume fraction of voids having an equivalent sphere diameter equal to or larger than 1 µm and smaller than 10 µm in a surface part is defined as Rf, an Al bonding wire or an Al bonding ribbon in which a ratio (Rf/Rd) falls within a specific range can solve the above problem, and have further investigated the problem based on such knowledge to complete the present invention.

That is, the present invention includes the following content.
<1> An Al bonding wire or an Al bonding ribbon containing 3.0% by mass or more and 20.0% by mass or less of Si, wherein
   a closed curve representing an outer periphery of a cross section in a direction perpendicular to a center axis of the Al bonding wire or the Al bonding ribbon is defined as S₀, a closed curve having a similar shape scaled by 2/3 with respect to S₀ is defined as S₁, and a closed curve having a similar shape scaled by 1/3 with respect to S₀ is defined as S₂, and S₀, S₁, and S₂ are arranged such that centroids thereof coincide with a centroid of the cross section in a direction perpendicular to the center axis of the Al bonding wire or the Al bonding ribbon, and a region surrounded by S₀ and S₁ is defined as a surface part and a region surrounded by S₂ is defined as a core part, and
   when a volume fraction of voids having an equivalent sphere diameter equal to or larger than 1 µm and smaller than 10 µm in the core part measured by X-ray Computed Topograpy(CT) analysis is defined as Rd and a volume fraction of voids having an equivalent sphere diameter equal to or larger than 1 µm and smaller than 10 µm in the surface part is defined as Rf, a ratio (Rf/Rd) is equal to or larger than 0.005 and equal to or smaller than 0.50.
<2> The Al bonding wire or the Al bonding ribbon according to <1>, wherein, when the number of the Si phases having an equivalent circle diameter equal to or larger than 0.5 µm and equal to or smaller than 0.8 µm in an L cross-section (cross section in a center axis direction including the center axis) is defined as Ns, and the number of the Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.
<3> The Al bonding wire or the Al bonding ribbon according to <1> or <2>, further containing 10 mass ppm or more and 800 mass ppm or less of one or more of Sr, Na, Eu, and P in total.
<4> The Al bonding wire or the Al bonding ribbon according to any one of <1> to <3>, further containing 100 mass ppm or more and 1500 mass ppm or less of one or more of Ni, Ti, Fe, and Mg in total.
<5> The Al bonding wire or the Al bonding ribbon according to any one of <1> to <4>, wherein a total concentration of elements other than Al, Si, Sr, Na, Eu, P, Ni, Ti, Fe, and Mg in the Al bonding wire or the Al bonding ribbon is equal to or smaller than 0.5 % by mass.
<6> The Al bonding wire or the Al bonding ribbon according to any one of <2> to <5>, wherein an equivalent circle diameter of the Si phase and the number of the Si phases are values measured by using an SEM-EDS-EBSD apparatus.
<7> The Al bonding wire or the Al bonding ribbon according to any one of <1> to <6>, used for a semiconductor device.
<8> A semiconductor device comprising the Al bonding wire or the Al bonding ribbon according to any one of <1> to <7>.

### EFFECT OF THE INVENTION

According to the present invention, it is possible to provide an Al bonding wire or an Al bonding ribbon that exhibits excellent rapid temperature cycle reliability even in a rapid temperature cycle test in which an upper limit temperature is high, which is required for next-generation SiC power semiconductors, and a semiconductor device obtained by using the Al bonding wire or the Al bonding ribbon.

### BRIEF DESCRIPTION OF DRAWINGS

FIG. 1 is a schematic diagram for explaining, regarding an Al bonding wire, a measurement target surface (inspection surface) when measuring a small-diameter ratio of a Si phase. The measurement target surface is a cross section in a center axis direction including a center axis (L cross-section) of the Al bonding wire.
FIG. 2 is a schematic diagram for explaining, regarding an Al bonding ribbon, a measurement target surface (inspection surface) when measuring a small-diameter ratio of a Si phase. The measurement target surface is a cross section in a center axis direction including a center axis (L cross-section) of the Al bonding ribbon.
FIG. 3 is an example of a luminance histogram created when a threshold of luminance between a void or an outer space and a substance is determined in X-ray CT analysis.
FIG. 4 is an example of a graph representing a number distribution of an equivalent circle diameter of a Si phase in the L cross-section.
FIG. 5 is a schematic diagram illustrating a relation among S₀, S₁, and S₂, and a core part, an intermediate part, and a surface part in a case of the Al bonding wire.
FIG. 6 is a schematic diagram illustrating a relation among S₀, S₁, and S₂, and a core part, an intermediate part, and a surface part in a case of the Al bonding ribbon.

### EMBODIMENT FOR CARRYING OUT THE INVENTION [0020]

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

### [Al bonding wire or Al bonding ribbon]

An Al bonding wire or an Al bonding ribbon according to the present invention is an Al bonding wire or an Al bonding ribbon containing 3.0% by mass or more and 20.0% by mass or less of Si, wherein
a closed curve representing an outer periphery of a cross section in a direction perpendicular to a center axis of the Al bonding wire or the Al bonding ribbon is defined as S₀, a closed curve having a similar shape scaled by 2/3 with respect to S₀ is defined as S₁, and a closed curve having a similar shape scaled by 1/3 with respect to S₀ is defined as S₂, and S₀, S₁ and S₂ are arranged such that centroids thereof coincide with a centroid of the cross section in a direction perpendicular to the center axis of the Al bonding wire or the Al bonding ribbon, and a region surrounded by S₀ and S₁ is defined as a surface part and a region surrounded by S₂ is defined as a core part, and
when a volume fraction of voids having an equivalent sphere diameter equal to or larger than 1 µm and smaller than 10 µm in the core part measured by X-ray Computed Topograpy (CT) analysis is defined as Rd and a volume fraction of voids having an equivalent sphere diameter equal to or larger than 1 µm and smaller than 10 µm in the surface part is defined as Rf, a ratio (Rf/Rd) (hereinafter also referred to as a "void inclination ratio") is equal to or larger than 0.005 and equal to or smaller than 0.50.

The Al bonding wire or the Al bonding ribbon according to the present invention contains 3.0% by mass or more and 20.0% by mass or less of Si, and includes the Al phase in which Si is dissolved in Al as a solid solution and a Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 25 µm, which is coarse. On the other hand, the Si precipitate is formed from a solid state, and has a small size of about 0.1 µm to several micrometers. The Si phase has a smaller coefficient of linear thermal expansion than that of Al, contributes to reduction of a difference in coefficient of linear thermal expansion between the Al bonding wire or the Al bonding ribbon and the semiconductor chip, and may reduce thermal stress, thereby exhibiting an effect of improving rapid temperature cycle reliability.

In the present invention, a "wire" and a "ribbon" are classified not by a shape but by a manufacturing method thereof. That is, the term "wire" refers to "a connection material manufactured by wire-drawing processing using a die", and the term "ribbon" refers to "a connection material manufactured by a rolling process". A "wire" usually has a circular cross-sectional shape, and a "ribbon" usually has a rectangular or substantially rectangular cross-sectional shape.

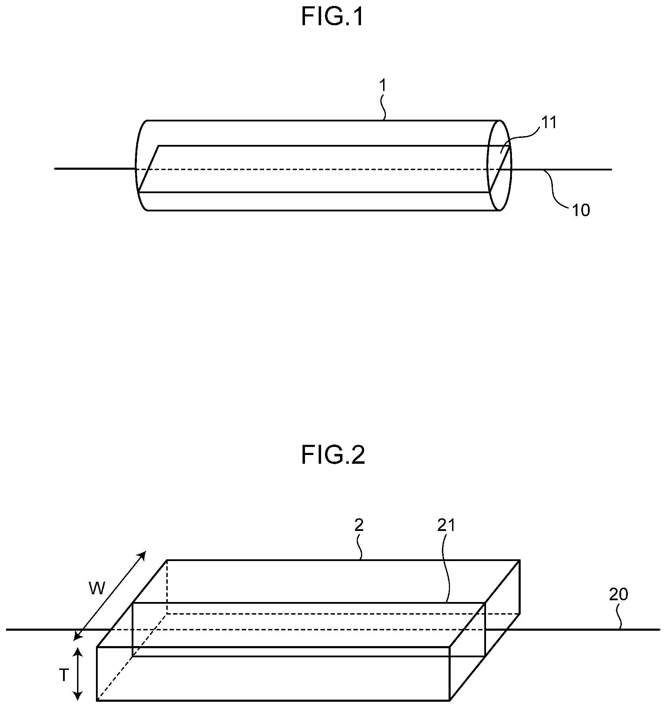

That is, the center axis of the Al bonding wire and the cross section in the center axis direction including the center axis (L cross-section) are as illustrated in FIG. 1. FIG. 1 illustrates a case of the Al bonding wire having a circular cross-sectional shape. In a case of the Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and perpendicular to the width W direction (FIG. 2). Specifically, the center axis of the Al bonding ribbon and the cross section in the center axis direction including the center axis (L cross-section) are as illustrated in FIG. 2. When cross-sectional processing is performed to expose the L cross-section of the Al bonding wire, it may be deviated from the center axis of the Al bonding wire. At this point, if the length of the L cross-section in the direction perpendicular to the center axis is 90% or more of a wire diameter of the Al bonding wire, the cross section can be regarded as a cross section including the center axis.

### -Void inclination ratio-

As described above, in a case of using a connection material composed only of high-purity Al in a temperature cycle test, there is a problem in that a crack develops at a relatively high speed inside the wire or the ribbon, and temperature cycle reliability is lowered. It has been confirmed that, in an Al alloy to which Si is added at a high concentration, thermal expansion of the wire or the ribbon can be reduced, and temperature cycle reliability can be improved. In a rapid TCT close to a condition of real use, it has been confirmed that, even with an Al bonding wire or an Al bonding ribbon the reliability of which is not lowered when being evaluated by a conventional TCT, bonding strength may be lowered and a lifetime of wire (or ribbon) bond may be shortened. This is considered to be because, since a temperature changing speed is high in the rapid TCT, thermal stress at a bonding part is considered to increase as compared with that in the conventional TCT. Furthermore, when the upper limit temperature of the rapid TCT becomes high, for example 185°C, bonding strength is likely to be further lowered, and further improvement in rapid temperature cycle reliability at a high temperature is required to satisfy rapid temperature cycle reliability required for a next-generation power semiconductor device having high heat resistance, such as SiC.

Due to an increase in the upper limit temperature of the rapid temperature cycle test, a difference in thermal expansion between the Al bonding wire or the Al bonding ribbon and the SiC semiconductor is increased, and thermal distortion at a bonding part of the wire or the ribbon increases. In the wire or the ribbon of an Al alloy to which Si is added at a high concentration (hereinafter, referred to as a "high-concentration Al-Si alloy"), a Si phase that reduces thermal expansion is formed, thereby reducing thermal distortion of the entire wire or ribbon and acting advantageously to suppress generation of a crack in the wire or the ribbon (hereinafter, referred to as a "crack in the wire"). However, when a failure mode in the rapid TCT in which the upper limit temperature is 185°C was observed, it was found that generation of a crack in an Al-based electrode film that is a bonding counterpart (hereinafter, referred to as a "crack in the electrode") is a cause of the failure. Since the Al-based electrode film is softer than the high-concentration Al-Si alloy wire or ribbon, thermal stress in the high-temperature rapid TCT propagates to the electrode, and it becomes a problem in that a crack develops in the electrode. Since a failure mechanism in the rapid TCT changes from a general crack in the wire to a crack in the electrode, material design focusing on improvement of the crack in the electrode is required.

As a result of earnest investigation to solve the problem described above, the present inventors have found that formation of minute voids in the high-concentration Al-Si alloy wire or ribbon and an inclined structure in which a distribution of void volume in the wire or the ribbon is varied from a surface region toward a center region contribute to suppression of a crack in the electrode in a high-temperature rapid TCT test.

Specifically, the present inventors have found that voids having a size in order of several micrometers are present in the Al-Si alloy wire or ribbon, and that the voids are mainly formed around the Si phase. This is considered to be because voids are formed at a wire-drawing step or a rolling step of making an Al-Si alloy wire or ribbon. At the wire-drawing step or the rolling step, deformation of the hard Si phase is suppressed, whereas the Al phase around the Si phase is plastically deformed easily, so that voids can be formed around the Si phase. Furthermore, in a region in which voids are dispersed, there is an effect of relieving stress and distortion in the wire or the ribbon during a temperature change in the rapid TCT. By forming the Si phase and voids at positions close to each other, in addition to a high effect of the Si phase reducing thermal expansion, the voids serve to buffer thermal stress accompanying temperature change, whereby effects such as reduction of thermal expansion and reduction of thermal stress are further enhanced. When the upper limit temperature of the rapid temperature cycle test becomes high, a difference in thermal expansion between the wire or the ribbon and the semiconductor increases, so that, when the temperature becomes high, a function of the voids to buffer thermal stress becomes more important.

In addition, since a size of the void is relatively small, propagation of distortion is locally improved, and an effect of reducing crack development in the electrode is enhanced. When the void grows coarsely or develops onto a crack, there is a concern that wire breakage is caused at the wire-drawing step or the rolling step. Therefore, regarding voids related to bonding reliability, voids having an equivalent sphere diameter equal to or larger than 1 µm and smaller than 10 µm are targeted by X-ray CT analysis.

Providing an inclined structure in which voids in the surface part of the wire or the ribbon are fewer than those in the core part is advantageous when a temperature change is severe, and has a high effect of improving a bonding lifetime in the rapid TCT. This is considered to be because, in a case in which voids are few in the surface region, efficiency with which an action of reducing thermal expansion of the Si phase and an effect of reducing thermal distortion propagate to an electrode side of the bonding interface is improved. Although a detailed mechanism is unknown, it is estimated that voids partially absorb thermal distortion with respect to a rapid temperature change.

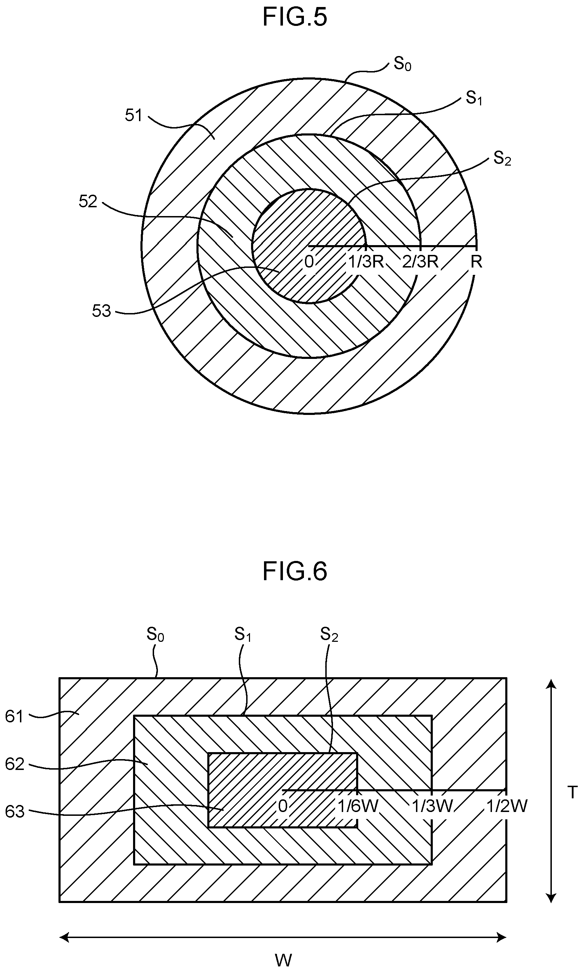

Specifically, a cross section is divided into three parts and distinguished into a core part, an intermediate part, and a surface part from a center, and volume fractions of voids in the respective regions are compared with each other. That is, a closed curve representing an outer periphery of the cross section in the direction perpendicular to the center axis of the Al bonding wire or the Al bonding ribbon is defined as S₀, a closed curve having a similar shape scaled by 2/3 with respect to S₀ is defined as S₁, and a closed curve having a similar shape scaled by 1/3 with respect to S₀ is defined as S₂, and S₀, S₁, and S₂ are arranged such that centroids thereof coincide with a centroid of the cross section in the direction perpendicular to the center axis of the Al bonding wire or the Al bonding ribbon, and a region surrounded by S₀ and S₁ is defined as the surface part and a region surrounded by S₂ is defined as the core part. Herein, "a closed curve having a similar shape scaled by 2/3 with respect to S₀ is defined as S₁" means that S₀ and S₁ are similar figures having a similarity ratio of 3:2. Similarly, "a closed curve having a similar shape scaled by 1/3 with respect to S₀ is defined as S₂" means that S₀ and S₂ are similar figures having a similarity ratio of 3:1. FIG. 5 illustrates a relation among S₀, S₁, and S₂, and the core part, the intermediate part, and the surface part in a case of the Al bonding wire. In a case of the Al bonding wire, assuming that a radius of a cross section in a direction perpendicular to the center axis of the Al bonding wire is R, a circular region on an inner side of a concentric circle having a radius of 1/3R is the core part, and a hollow circular region surrounded by a concentric circle having a radius of 2/3R and a concentric circle having the radius of R is the surface part. FIG. 6 illustrates a relation among S₀, S₁, and S₂, and the core part, the intermediate part, and the surface part in a case of the Al bonding ribbon.

When a volume fraction of voids having an equivalent sphere diameter equal to or larger than 1 µm and smaller than 10 µm in the core part measured by X-ray CT analysis is defined as Rd and a volume fraction of voids having an equivalent sphere diameter equal to or larger than 1 µm and smaller than 10 µm in the surface part is defined as Rf, a void inclination ratio (Rf/Rd) is equal to or larger than 0.005 and equal to or smaller than 0.50.

Regarding calculation of a volume fraction of voids, first, by X-ray CT analysis, a volume Vs of voids having an equivalent sphere diameter equal to or larger than 1 µm and smaller than 10 µm, a total volume Vg of voids of all sizes, and a volume Vm of a substance are calculated. Subsequently, a ratio (Vs/(Vg + Vm)) obtained by dividing Vs by a total volume (Vg + Vm) of the voids and the substance is calculated and defined as a void volume fraction. According to this method, volume fractions Rd and Rf of voids in the core part and the surface part, respectively, are calculated.

The following describes a reason why excellent rapid temperature cycle reliability is exhibited even in the rapid temperature cycle test in which the upper limit temperature is high when the void inclination ratio (Rf/Rd) is equal to or larger than 0.005 and equal to or smaller than 0.50. When the void inclination ratio (Rf/Rd) is equal to or larger than 0.005, it is possible to prevent an adverse effect from being caused by a difference in void volume fraction between the surface part and the core part becoming excessively large, and industrial manufacture can be performed relatively easily. In addition, when the void inclination ratio (Rf/Rd) is equal to or smaller than 0.50, it is possible to sufficiently increase a difference in void volume fraction between the surface part and the core part, and to obtain a sufficient improvement effect in the rapid temperature cycle test in which the upper limit temperature is high.

The present inventors have also confirmed that the Al bonding wire or the Al bonding ribbon according to the present invention exhibits an excellent shear force ratio. In evaluation of a bond quality of a 1st bonding part, when fracture occurs inside the bonding wire or the bonding ribbon in a shear test, it is difficult to accurately evaluate a bond quality of a high-strength material. In this regard, as a method for evaluating bonding strength while suppressing an influence of material strength, it is conceivable to perform determination based on a value obtained by normalizing shear force with material strength. As a result of investigating a relation between the material strength and the bond quality and the like, the present inventors have found that it is effective to calculate a ratio obtained by dividing shear force (SH) by 0.2% proof stress (PS) in a tensile test (SH/PS, hereinafter referred to as a "shear force ratio"). When factors that govern a value of apparent shear force of the 1st bonding part are decomposed, the factors can be divided into net bonding strength and deformation resistance of the wire or the ribbon. The latter deformation resistance correlates with yield strength at which the wire or the ribbon yields and starts plastic deformation during the shear test. Accordingly, to evaluate net bonding strength, it has been devised to exclude an influence of yield strength of the wire or the ribbon from apparent shear force. As this yield strength, 0.2% proof stress, which is a strength value when elongation in the tensile test is 0.2%, is used.

That is, the present inventors have found that a bonding state can be evaluated more accurately by using the shear force ratio (SH/PS) normalized with 0.2% proof stress (PS). When the shear force ratio shows a high value, it can be determined that favorable bonding is obtained at the bonding interface. By using the shear force ratio (SH/PS) as an index, when the wire or the ribbon having a high shear force ratio is used, both favorable bonding strength and reduction of bonding damage can be achieved, and performance excellent in temperature cycle reliability can be exhibited.

From a viewpoint of exhibiting excellent rapid temperature cycle reliability even in the rapid temperature cycle test in which the upper limit temperature is high, and from a viewpoint of exhibiting an excellent shear force ratio, a lower limit of the void inclination ratio (Rf/Rd) is equal to or larger than 0.005, preferably equal to or larger than 0.008, equal to or larger than 0.010, equal to or larger than 0.015, equal to or larger than 0.020, equal to or larger than 0.030, or equal to or larger than 0.050, more preferably equal to or larger than 0.080 or equal to or larger than 0.10, still more preferably equal to or larger than 0.12 or equal to or larger than 0.15, and particularly preferably equal to or larger than 0.18 or equal to or larger than 0.20. From a viewpoint of exhibiting excellent rapid temperature cycle reliability even in the rapid temperature cycle test in which the upper limit temperature is high, and from a viewpoint of exhibiting an excellent shear force ratio, an upper limit of the void inclination ratio (Rf/Rd) is equal to or smaller than 0.50, preferably equal to or smaller than 0.48 or equal to or smaller than 0.45, more preferably equal to or smaller than 0.42 or equal to or smaller than 0.40, still more preferably equal to or smaller than 0.38 or equal to or smaller than 0.35, and particularly preferably equal to or smaller than 0.32 or equal to or smaller than 0.30.

### -Si concentration-

A Si concentration in a range equal to or larger than 3.0% by mass and equal to or smaller than 20.0% by mass is useful in improving the shear force ratio, and reducing thermal distortion of the bonding part to improve temperature cycle reliability. Specifically, when the Si concentration is equal to or larger than 3.0% by mass, an improvement effect in rapid temperature cycle reliability can be increased. In addition, regarding an upper limit of the Si concentration, along with progress and optimization of equipment and conditions used for manufacturing and bonding of a wire or the like, higher values have become allowable while suppressing defects such as wire breakage during processing, deterioration of surface properties, reduction in initial bonding strength due to hardening, and damage to the semiconductor chip; however, when the Si concentration is equal to or smaller than 20.0% by mass, these defects can be favorably suppressed while improving the shear force ratio. From a viewpoint of obtaining favorable rapid temperature cycle reliability, the concentration of Si in the Al bonding wire or the Al bonding ribbon according to the present invention is equal to or larger than 3.0% by mass, preferably equal to or larger than 3.5% by mass, more preferably equal to or larger than 4.0% by mass, even more preferably equal to or larger than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. In addition, from a viewpoint of improving the shear force ratio while favorably suppressing defects such as reduction in initial bonding strength due to hardening and damage to the semiconductor chip, the concentration of Si in the Al bonding wire or the Al bonding ribbon according to the present invention is equal to or smaller than 20.0% by mass, and preferably equal to or smaller than 19.0% by mass, equal to or smaller than 18.0% by mass, equal to or smaller than 17.0% by mass, equal to or smaller than 16.0% by mass, equal to or smaller than 15.0% by mass, equal to or smaller than 14.5% by mass, equal to or smaller than 14.0% by mass, equal to or smaller than 13.5% by mass, equal to or smaller than 13.0% by mass, or equal to or smaller than 12.5% by mass. Furthermore, when hardness of the Al bonding wire or the Al bonding ribbon is high, the semiconductor chip tends to be easily damaged at the time of 1st bonding depending on bonding conditions of ultrasonic vibrations and loads. From a viewpoint of obtaining favorable bonding strength under a wider range of bonding conditions, the Si concentration in the Al bonding wire or the Al bonding ribbon according to the present invention is more preferably equal to or smaller than 12.0% by mass, still more preferably equal to or smaller than 11.5% by mass or equal to or smaller than 11.0% by mass, and particularly preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al bonding wire or the Al bonding ribbon according to the present invention, for example, an Inductively Coupled Plasma (ICP) emission spectrophotometer or an ICP mass spectrometer can be used. In a case in which elements derived from contaminants in the air, such as oxygen or carbon, are adsorbed on a surface of the Al bonding wire or the Al bonding ribbon, it is effective to clean it with acid or alkali depending on adsorbed substances before performing analysis.

### -Analysis of void by X-ray CT-

In the present invention, the void inclination ratio (Rf/Rd) is measured by using X-ray CT analysis. The X-ray CT analysis technology is excellent in nondestructively observing voids in a substance, and by performing three-dimensional image analysis based on data thereof, minute voids in a metal can be observed with high accuracy. The following exemplifies an analysis method for measuring voids in the Al bonding wire having a wire diameter of 300 µm. An analysis condition and the like are not limited thereto, and an appropriate analysis condition can be selected depending on an apparatus and a sample. As the X-ray CT apparatus, for example, a 3D X-ray microscope "Xradia 520 Versa" (manufactured by ZEISS) can be used. Main measurement conditions in X-ray CT are as follows. An X-ray voltage can be 40 kV, an X-ray output can be 3 W, a wavelength limiting filter can be LE1, and a magnification lens can be 4x. Under the conditions described above, it has been confirmed that a transmission image having a transmittance of 30% to 70% can be obtained. To observe minute voids, by setting a size per pixel to be about 0.7 µm/pixel, a region of about 700 µm × 700 µm × 700 µm can be measured as a measurement field of view. By fixing an end of a sample with a sample length of about 10 mm, a CT projection image can be measured by transmitting X-rays at a rotation angle of 360 degrees about an axis of the sample. After CT projection images at all angles are obtained, reconstruction processing such as center shift processing is performed, whereby three-dimensional image data can be acquired.

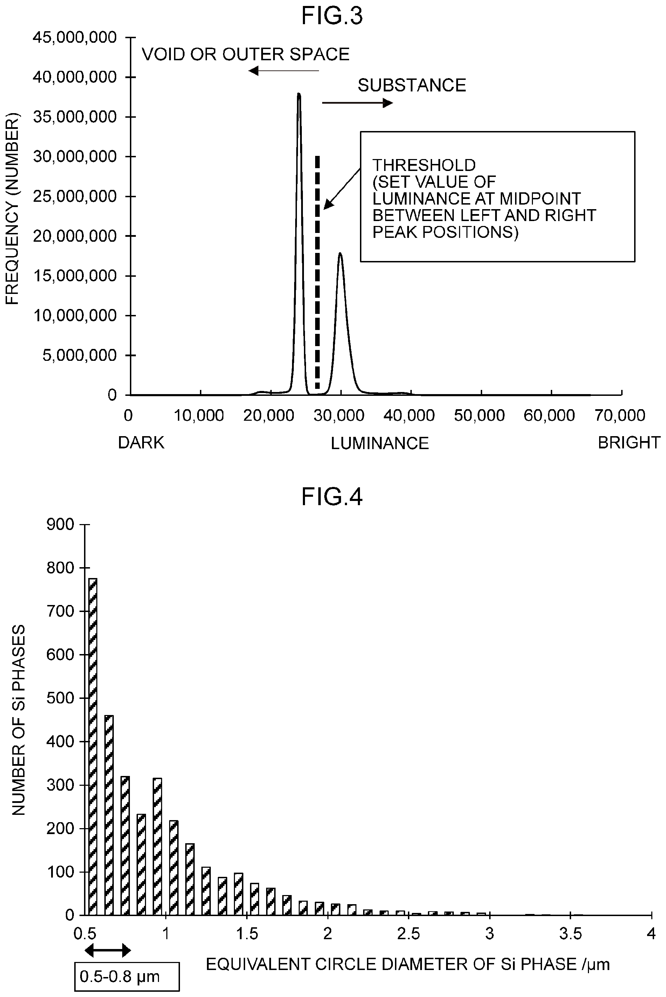

Next, the three-dimensional image data is analyzed by using image analysis software. As the image analysis software, Avizo Inspection can be used. Specifically, a luminance histogram (FIG. 3) is created by using measurement data. A luminance value at a midpoint between two peak positions corresponding to a void or an outer space and a substance is set as a threshold. An image data region showing a luminance lower than the threshold is identified as a void or an outer space (an environment around the sample). Next, with respect to the identified void and outer space, processing of selecting a region of the outer space and removing the region from the image data region is performed. Due to this, image data of only voids in the substance within the measurement region of the sample can be identified. Next, by similar processing, image data having a luminance higher than the threshold is identified as image data relating to the substance. This "substance" has mass and volume, and in the Al bonding wire or the Al bonding ribbon according to the present invention, Al, Si, a first element group, a second element group, and other elements, as well as alloys, oxides, intermetallic compounds, and the like thereof are included. In the X-ray CT analysis of the present invention, a pixel showing a luminance higher than the threshold described above is regarded as having a substance.

Analysis is performed on respective pieces of image data of the voids and the substance obtained as described above. The following specifically describes a method for calculating a volume fraction of voids having an equivalent sphere diameter equal to or larger than 1 µm and smaller than 10 µm. By using the image analysis software, the total volume Vs of voids having an equivalent sphere diameter equal to or larger than 1 µm and smaller than 10 µm, the total volume Vg of voids of all sizes, and the volume Vm of the substance are calculated. The ratio (Vs/(Vg + Vm)) obtained by dividing Vs by the total volume (Vg + Vm) of the voids and the substance is calculated as the void volume fraction. According to this method, the volume fractions Rd and Rf of voids in the core part and the surface part, respectively, are calculated.

### -Distribution of equivalent circle diameter of Si phase in L cross-section-

From a viewpoint of obtaining excellent rapid temperature cycle reliability even in a case in which the number of cycles is further increased in the rapid TCT in which the upper limit temperature is high, when the number of the Si phases having an equivalent circle diameter equal to or larger than 0.5 µm and equal to or smaller than 0.8 µm in the L cross-section of the Al bonding wire or the Al bonding ribbon is defined as Ns, and the number of the Si phases having an equivalent circle diameter equal to or larger than 0.5 µm in the L cross-section is defined as Nc, a ratio of Ns to Nc [Ns/Nc × 100 (%)] (hereinafter, also referred to as a "small-diameter ratio of the Si phase") is equal to or larger than 30% and equal to or smaller than 95%. A lower limit of the small-diameter ratio [Ns/Nc × 100 (%)] of the Si phase is preferably equal to or larger than 32%, equal to or larger than 35%, equal to or larger than 38%, equal to or larger than 40%, equal to or larger than 42%, or equal to or larger than 45%, more preferably equal to or larger than 48%, still more preferably equal to or larger than 50% or equal to or larger than 52%, and particularly preferably equal to or larger than 55% or equal to or larger than 60%. An upper limit of the small-diameter ratio [Ns/Nc × 100 (%)] of the Si phase is preferably equal to or smaller than 92%, equal to or smaller than 90%, equal to or smaller than 88%, or equal to or smaller than 85%, more preferably equal to or smaller than 82% or equal to or smaller than 80%, still more preferably equal to or smaller than 78% or equal to or smaller than 75%, and particularly preferably equal to or smaller than 72% or equal to or smaller than 70%. In one embodiment, the small-diameter ratio [Ns/Nc × 100 (%)] of the Si phase is preferably equal to or larger than 40% and equal to or smaller than 90%.

A reason why the ratio of the Si phases having an equivalent circle diameter equal to or larger than 0.5 µm and equal to or smaller than 0.8 µm is important is considered as follows. That is, since the Si phase having an equivalent circle diameter equal to or larger than 0.5 µm has a sufficiently large volume, an action of reducing thermal expansion can be sufficiently obtained. It is also appropriate to target the Si phase having an equivalent circle diameter equal to or larger than 0.5 µm from a viewpoint of analysis accuracy of current analysis apparatuses of EDS and EBSD. On the other hand, in the Si phase having an equivalent circle diameter equal to or smaller than 0.8 µm, stress and distortion in the vicinity of the bonding interface due to the Si phase become sufficiently uniform. In addition, a reason why excellent rapid temperature cycle reliability can be obtained even in a case in which the number of cycles is further increased in the rapid TCT in which the upper limit temperature is high when the small-diameter ratio [Ns/Nc × 100 (%)] of the Si phase falls within a range equal to or larger than 30% and equal to or smaller than 95% is considered as follows. That is, when the small-diameter ratio of the Si phase is equal to or larger than 30%, the Si phases having a small equivalent circle diameter are sufficiently present, a distribution of thermal distortion becomes uniform, and rapid temperature cycle reliability is stabilized. On the other hand, when the small-diameter ratio of the Si phase is equal to or smaller than 95%, a total volume of the Si phases increases and an effect of reducing thermal expansion of the entire bonding region can be maintained at a high level, and an effect of improving rapid temperature cycle reliability can be sufficiently increased. In one embodiment, in a case in which the void inclination ratio (Rf/Rd) of the Al bonding wire or the Al bonding ribbon according to the present invention is equal to or larger than 0.005 and equal to or smaller than 0.50, the Al bonding wire or the Al bonding ribbon exhibits excellent rapid temperature cycle reliability in the rapid temperature cycle test with the number of cycles of 10,000, whereas in a case in which the small-diameter ratio of the Si phase of the Al bonding wire or the Al bonding ribbon is equal to or larger than 30% and equal to or smaller than 95%, the Al bonding wire or the Al bonding ribbon exhibits excellent rapid temperature cycle reliability even in a rapid temperature cycle test with the number of cycles of 13,000.

Herein, each Si phase is formed in a particulate shape, and it has been confirmed that the number of particles of the Si phase has a large influence on thermal distortion at the bonding interface. Accordingly, rapid temperature cycle reliability can be determined by using a ratio of the number of particles of the Si phase. On the other hand, when areas of the particles are used, an influence of coarse particles is overestimated, so that it is difficult to accurately evaluate correlation with rapid temperature cycle reliability.

### -Method for measuring equivalent circle diameter of Si phase and method for calculating small-diameter ratio-

The following describes a method for measuring the equivalent circle diameter of the Si phase in the L cross-section of the Al bonding wire or the Al bonding ribbon. The equivalent circle diameter of the Si phase in the L cross-section can be measured by using an SEM-EDS-EBSD apparatus. Specifically, a method of combining information of Al concentration and Si concentration obtained by Scanning Electron Microscope-Energy Dispersive X-ray Spectroscopy (SEM-EDS) and information of a crystal orientation obtained by Electron BackScatter Diffraction (EBSD) can be used. More specifically, in a measurement region designating the L cross-section of the Al bonding wire or the Al bonding ribbon to be an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions Inc.) attached to a Field Emission-Scanning Electron Microscope (FE-SEM) apparatus. For a region that is specified as the Si phase, a crystal orientation can be analyzed by using the analysis software attached to the apparatus. If an orientation difference between measurement points is equal to or larger than 15°, it is determined to be a crystal grain boundary, and an equivalent circle diameter is calculated. In a process of obtaining the small-diameter ratio of the Si phase, calculation is performed excluding a part in which the crystal orientation cannot be measured, and a part in which the crystal orientation can be measured but reliability of orientation analysis is low. Thus, in one embodiment, the small-diameter ratio of the Si phase in the L cross-section of the Al bonding wire or the Al bonding ribbon according to the present invention is calculated through procedures from (1) to (3) as follows.
(1) The L cross-section of the Al bonding wire or the Al bonding ribbon is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. The number of crystal grains identified as the Si phase is counted, and a total number Nc of particles of the Si phase is obtained. Herein, the Si phase having an equivalent circle diameter equal to or larger than 0.5 µm is targeted. In consideration of analysis accuracy of current analysis apparatuses of EDS and EBSD, fine ones smaller than 0.5 µm are excluded from the target. In addition, the number Ns of the Si phases having an equivalent circle diameter in a range equal to or larger than 0.5 µm and equal to or smaller than 0.8 µm is counted. The ratio of Ns to Nc [Ns/Nc × 100 (%)] (small-diameter ratio of the Si phase) is then calculated.

In the procedure of (2) described above, setting of Tolerance (%) can be selected in a range from 20 to 40%, and about 30% is preferable for comparison in standard analysis of the L cross-section of the Al bonding wire or the Al bonding ribbon. The following supplementarily describes a procedure of adjusting the Tolerance. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, the small-diameter ratio of the Si phase is calculated as an average value (arithmetic mean) of respective values of orientation ratios obtained by measuring at three or more parts. In selecting the measurement region, from a viewpoint of securing objectivity of measurement data, it is preferable to acquire a sample for measurement to be measured from the Al bonding wire or the Al bonding ribbon as a measurement target at intervals of 50 cm or more with respect to the center axis direction of the Al bonding wire or the Al bonding ribbon. In the present invention, the measurement region for the crystal orientation measured by the EBSD method is determined so that the length in the center axis direction of the Al bonding wire or the Al bonding ribbon is equal to or larger than 300 µm and smaller than 800 µm, and the entire Al bonding wire or the entire Al bonding ribbon is preferably accommodated therein in a direction perpendicular to the center axis of the Al bonding wire or the Al bonding ribbon, but if the size is large and the entire region is difficult to be measured, it can be adjusted in a range smaller than 600 µm.

An example of measurement results is illustrated in FIG. 4. A horizontal axis indicates an equivalent circle diameter of the Si phase, each section is indicated with a width of 0.1 µm, and a vertical axis indicates the number of particles. A range equal to or larger than 0.5 µm and equal to or smaller than 0.8 µm is indicated by a double-headed arrow, and the particle number ratio [Ns/Nc × 100 (%)] in this section is 50%. In the rapid temperature cycle test of this Al bonding wire, it has been confirmed that strength reduction is suppressed to be low even when a maximum temperature is increased to 185°C, and favorable rapid temperature cycle reliability is obtained.

### -Addition of Sr, Na, Eu, and P-

The Al bonding wire or the Al bonding ribbon according to the present invention may further contain one or more of Sr, Na, Eu, and P (hereinafter, also referred to as a "first element group"). A total concentration of the first element group may be 0 mass ppm, preferably equal to or larger than 1 mass ppm, more preferably equal to or larger than 3 mass ppm, still more preferably equal to or larger than 5 mass ppm, and particularly preferably equal to or larger than 8 mass ppm or equal to or larger than 10 mass ppm. An upper limit of the total concentration of the first element group is preferably equal to or smaller than 10000 mass ppm or equal to or smaller than 8000 mass ppm, more preferably equal to or smaller than 5000 mass ppm or equal to or smaller than 3000 mass ppm, still more preferably equal to or smaller than 2000 mass ppm or equal to or smaller than 1000 mass ppm, and particularly preferably equal to or smaller than 900 mass ppm or equal to or smaller than 800 mass ppm. In one embodiment, the total concentration of the first element group is preferably equal to or larger than 10 mass ppm and equal to or smaller than 800 mass ppm.

When the Al bonding wire or the Al bonding ribbon according to the present invention further contains 10 mass ppm or more and 800 mass ppm or less of one or more of Sr, Na, Eu, and P in total, a generation frequency of wire breakage can be reduced in wire-drawing processing for the Al bonding wire or the Al bonding ribbon. In an Al alloy containing a high concentration of Si equal to or larger than 3.0% by mass and equal to or smaller than 20.0% by mass, a frequency of wire breakage at a wire-drawing step tends to be increased. This may be because particles of the Si phase crystallized at the time of solidification cause stress concentration during the wire-drawing processing, and induce wire breakage. It is estimated that stress concentration during wire-drawing can be relieved and wire breakage can be reduced due to effects such that the particulate Si phase may be uniformly distributed, and/or growth and coarsening of the Si phase may be suppressed by adding the first element group. It is considered that an effect of relieving stress concentration during wire-drawing can be enhanced by controlling the void inclination ratio and adding the first element group thereto.

From a viewpoint of reducing the generation frequency of wire breakage in the wire-drawing processing, the total concentration of the first element group in the Al bonding wire or the Al bonding ribbon according to the present invention is more preferably equal to or larger than 20 mass ppm, and still more preferably equal to or larger than 30 mass ppm, equal to or larger than 40 mass ppm, or equal to or larger than 50 mass ppm, and an upper limit thereof is preferably equal to or smaller than 750 mass ppm, more preferably equal to or smaller than 740 mass ppm, equal to or smaller than 720 mass ppm, or equal to or smaller than 700 mass ppm, still more preferably equal to or smaller than 680 mass ppm, equal to or smaller than 650 mass ppm, equal to or smaller than 620 mass ppm, or equal to or smaller than 600 mass ppm, and particularly preferably equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains one or more elements of the first element group, it may contain any one element of the first element group, may contain any two elements of the first element group, may contain any three elements of the first element group, or may contain all of four elements of the first element group. In a case in which the Al bonding wire or the Al bonding ribbon according to the present invention contains one or more elements of the first element group, it may contain Sr, may contain Na, may contain Eu, and/or may contain P.

In a case in which the Al bonding wire or the Al bonding ribbon according to the present invention contains Sr of the first element group, a concentration of Sr may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Sr is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Sr is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Sr is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Na of the first element group, a concentration of Na may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Na is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Na is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Na is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Eu of the first element group, a concentration of Eu may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Eu is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Eu is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Eu is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains P of the first element group, a concentration of P may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of P is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of P is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of P is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

### -Addition of Ni, Ti, Fe, and Mg-

The Al bonding wire or the Al bonding ribbon according to the present invention may further contain one or more of Ni, Ti, Fe, and Mg (hereinafter, also referred to as a "second element group"). A total concentration of the second element group may be 0 mass ppm, preferably equal to or larger than 1 mass ppm or equal to or larger than 3 mass ppm, more preferably equal to or larger than 5 mass ppm or equal to or larger than 8 mass ppm, still more preferably equal to or larger than 10 mass ppm or equal to or larger than 30 mass ppm, and particularly preferably equal to or larger than 50 mass ppm, equal to or larger than 80 mass ppm, or equal to or larger than 100 mass ppm. An upper limit of the total concentration of the second element group is preferably equal to or smaller than 10000 mass ppm, more preferably equal to or smaller than 8000 mass ppm, still more preferably equal to or smaller than 5000 mass ppm, and particularly preferably equal to or smaller than 3000 mass ppm, equal to or smaller than 2000 mass ppm, equal to or smaller than 1800 mass ppm, equal to or smaller than 1600 mass ppm, or equal to or smaller than 1500 mass ppm. In one embodiment, the total concentration of the second element group is preferably equal to or larger than 100 mass ppm and equal to or smaller than 1500 mass ppm.

When the Al bonding wire or the Al bonding ribbon according to the present invention further contains 100 mass ppm or more and 1500 mass ppm or less of one or more of Ni, Ti, Fe, and Mg in total, generation of scratches and scrapes on the surface of the Al bonding wire or the Al bonding ribbon can be suppressed, and a smooth surface can be formed. In an Al alloy containing a high concentration of Si equal to or larger than 3.0% by mass and equal to or smaller than 20.0% by mass, scratches and scrapes may be generated on a surface thereof during the wire-drawing processing due to surface hardening and the detachment of the Si phases and Al oxides present on the surface. As a result, this can lead to the Al bonding wire or the Al bonding ribbon with large surface unevenness. It is estimated that scratches and scrapes during the wire-drawing processing can be reduced by adding the second element group to accelerate stabilization of the Al oxide on the surface of the Al bonding wire or the Al bonding ribbon, refinement and hardening of structures of Al crystal grains, and the like. It is considered that an effect of suppressing generation of scratches and scrapes on the surface of the Al bonding wire or the Al bonding ribbon to form a smooth surface can be enhanced by controlling the void inclination ratio and adding the second element group thereto.

From a viewpoint of suppressing generation of scratches and scrapes on the surface to form the Al bonding wire or the Al bonding ribbon having a smooth surface, the total concentration of the second element group in the Al bonding wire or the Al bonding ribbon according to the present invention is more preferably equal to or larger than 150 mass ppm, and still more preferably equal to or larger than 200 mass ppm, equal to or larger than 250 mass ppm, or equal to or larger than 300 mass ppm, and an upper limit thereof is more preferably equal to or smaller than 1200 mass ppm, still more preferably equal to or smaller than 1000 mass ppm, equal to or smaller than 900 mass ppm, or equal to or smaller than 800 mass ppm, and particularly preferably equal to or smaller than 700 mass ppm, equal to or smaller than 600 mass ppm, or equal to or smaller than 500 mass ppm.

In a case in which the Al bonding wire or the Al bonding ribbon according to the present invention contains one or more elements of the second element group, it may contain any one element of the second element group, may contain any two elements of the second element group, may contain any three elements of the second element group, or may contain all of four elements of the second element group. In a case in which the Al bonding wire or the Al bonding ribbon according to the present invention contains one or more elements of the second element group, it may contain Ni, may contain Ti, may contain Fe, and/or may contain Mg.

In a case in which the Al bonding wire or the Al bonding ribbon according to the present invention contains Ni of the second element group, a concentration of Ni may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ni is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ni is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ni is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Ti of the second element group, a concentration of Ti may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ti is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ti is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ti is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Fe of the second element group, a concentration of Fe may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Fe is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Fe is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Fe is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Mg of the second element group, a concentration of Mg may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Mg is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Mg is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Mg is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

As an aluminum raw material for manufacturing the Al bonding wire or the Al bonding ribbon according to the present invention, it is preferable to use Al having a purity of 4N (Al: 99.99% by mass or more), and more preferable to use Al having a purity of 5N (Al: 99.999% by mass or more) in which an amount of impurities is smaller. In one embodiment, Al having a purity of 3N (Al: 99.9 % by mass or more) may be used.

In a range of not inhibiting the effect of the present invention, the Al bonding wire or the Al bonding ribbon according to the present invention may further contain elements other than Al, Si, the first element group, and the second element group (hereinafter, also referred to as "other elements"). That is, the "other elements" mean elements other than Al, Si, Sr, Na, Eu, P, Ni, Ti, Fe, and Mg, and the Al bonding wire or the Al bonding ribbon according to the present invention may further contain elements other than Al, Si, Sr, Na, Eu, P, Ni, Ti, Fe, and Mg. A total concentration of the other elements in the Al bonding wire or the Al bonding ribbon is not particularly limited in a range of not inhibiting the effect of the present invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al bonding wire or the Al bonding ribbon according to the present invention consists of Al and the other elements. Thus, according to a preferred embodiment, the Al bonding wire or the Al bonding ribbon according to the present invention consists of Al, Si, and the other elements. According to another preferred embodiment, the Al bonding wire or the Al bonding ribbon according to the present invention consists of Al, Si, one or more elements of the first element group, and the other elements. According to yet another preferred embodiment, the Al bonding wire or the Al bonding ribbon according to the present invention consists of Al, Si, one or more elements of the second element group, and the other elements. According to yet another preferred embodiment, the Al bonding wire or the Al bonding ribbon according to the present invention consists of Al, Si, one or more elements of the first element group, one or more elements of the second element group, and the other elements.

According to one embodiment, a balance of the Al bonding wire or the Al bonding ribbon according to the present invention consists of Al and inevitable impurities. Thus, according to a preferred embodiment, the Al bonding wire or the Al bonding ribbon according to the present invention consists of Al, Si, and inevitable impurities. According to another preferred embodiment, the Al bonding wire or the Al bonding ribbon according to the present invention consists of Al, Si, one or more elements of the first element group, and inevitable impurities. According to yet another preferred embodiment, the Al bonding wire or the Al bonding ribbon according to the present invention consists of Al, Si, one or more elements of the second element group, and inevitable impurities. According to yet another preferred embodiment, the Al bonding wire or the Al bonding ribbon according to the present invention consists of Al, Si, one or more elements of the first element group, one or more elements of the second element group, and inevitable impurities.

According to a preferred embodiment, the Al bonding wire or the Al bonding ribbon according to the present invention does not have a coating that contains a metal other than Al as a main component on an outer periphery of the Al bonding wire or the Al bonding ribbon. Herein, the "coating that contains a metal other than Al as a main component" means the coating in which the content of the metal other than Al is 50% by mass or more.

The Al bonding wire or the Al bonding ribbon according to the present invention may be an Al bonding wire or an Al bonding ribbon. In a case in which the present invention is the Al bonding wire, a wire diameter thereof is not particularly limited, and may be equal to or larger than 50 µm, equal to or larger than 60 µm, equal to or larger than 80 µm, equal to or larger than 100 µm, equal to or larger than 120 µm, equal to or larger than 140 µm, equal to or larger than 150 µm, equal to or larger than 180 µm, or equal to or larger than 200 µm, for example. An upper limit of the wire diameter is not particularly limited, and may be equal to or smaller than 600 µm, equal to or smaller than 550 µm, equal to or smaller than 500 µm, equal to or smaller than 450 µm, or equal to or smaller than 400 µm, for example. In one embodiment, the wire diameter of the Al bonding wire according to the present invention may fall within a range from 100 to 600 µm, and preferably falls within a range from 200 to 400 µm. In a case in which the present invention is the Al bonding ribbon, dimensions (width W × thickness T) of a cross section having a rectangular shape or a substantially rectangular shape are not particularly limited, for example, W may be 100 to 3000 µm and T may be 50 to 600 µm.

The Al bonding wire or the Al bonding ribbon according to the present invention can exhibit excellent rapid temperature cycle reliability even in the rapid temperature cycle test in which the upper limit temperature is high. Thus, the Al bonding wire or the Al bonding ribbon according to the present invention can be preferably used as an Al bonding wire or an Al bonding ribbon for a semiconductor device. Particularly, the Al bonding wire or the Al bonding ribbon according to the present invention can be preferably used as an Al bonding wire or an Al bonding ribbon for a power semiconductor device, and can be more preferably used as an Al bonding wire or an Al bonding ribbon for a SiC power semiconductor device.

### -Method for manufacturing Al bonding wire or Al bonding ribbon-

The following describes an example of a method for manufacturing the Al bonding wire or the Al bonding ribbon according to the present invention. The following describes an example of manufacture of the Al bonding wire.

Al and alloy elements as raw materials preferably have a high purity. Al preferably has a purity of 99.5 % by mass or more and includes inevitable impurities as a balance, more preferably has a purity of 99.9 % by mass or more and includes inevitable impurities as a balance, and still more preferably has a purity of 99.99 % by mass or more and includes inevitable impurities as a balance. Si, the first element group, the second element group, and the other elements used as alloy elements preferably have a purity of 99.9% by mass or more and include inevitable impurities as a balance, and more preferably have a purity of 99.99 % by mass or more and include inevitable impurities as a balance. In a casting process for melting and solidifying an Al alloy used for the Al bonding wire, continuous casting can be used. In continuous casting, while a melted liquid obtained by melting an Al raw material and raw materials of alloy elements is cast into a water-cooled mold, a casting material (ingot) is continuously drawn out from a lower side of the mold. An atmosphere in the furnace at the time of melting is preferably an inert atmosphere or a reducing atmosphere to prevent Al, Si, the first element group, the second element group, and the other elements constituting the wire from being excessively oxidized. The highest end-point temperature of melted metal at the time of melting preferably falls within a range equal to or higher than 800°C and lower than 1050°C, considering to facilitate control of the shape and the size of the Si phase at the time of solidification and the like while securing fluidity of the melted metal. As a method for cooling after the melting, water cooling, furnace cooling, air cooling, and the like can be used.

By performing solution treatment to heat the ingot having a cylindrical shape obtained by melting at a high temperature, and repeatedly performing wire-drawing processing using dies thereon, the wire having a desired wire diameter can be manufactured. The wire after being subjected to the wire-drawing processing can be used as an Al bonding wire by performing final heat treatment using the electric furnace.

To control the void inclination ratio and the small-diameter ratio of the Si phase, it is effective to control a heat treatment condition for solution treatment, homogenization processing, or final heat treatment, and a wire-drawing processing condition, and the like. At the time of wire-drawing processing, it is effective to use a lubricating liquid to secure lubricity at a contact interface between the wire and the die.

### <Control of void inclination ratio>

In particular, to control the void inclination ratio of the wire, it is effective to control a wire feeding speed (wire-drawing speed) at the wire-drawing processing step, an area reduction ratio of the die, lubricity, and an atmosphere of intermediate annealing. These will be individually described below.

Assisting deformation of a surface region by controlling the wire feeding speed at a high speed in accordance with a wire diameter at which wire-drawing processing is performed is effective for accelerating a concentration inclination of voids. As a specific example, at a step of performing wire-drawing processing in a range from a wire diameter of 1/2 of a wire diameter at which wire-drawing processing is started to a final wire diameter, it is preferable that an average of the wire-drawing speed is equal to or higher than 20 m/min and lower than 50 m/min.

Regarding an area reduction ratio of the die at the wire-drawing processing, it is effective to perform wire-drawing with a high area reduction ratio for a large diameter and with a low area reduction ratio for a small diameter. In a first half of the process, by concentrating processing distortion at a center of the wire in wire-drawing with a high area reduction ratio to accelerate an increase in voids in the core part, and in a latter half of the process, by gently deforming a vicinity of a surface in wire-drawing with a low area reduction ratio, it is possible to reduce voids in the surface part. As a specific example thereof, it is preferable that an area reduction ratio of the die from the wire diameter at which wire-drawing processing is started to a wire diameter of 1/2 thereof falls within a range equal to or larger than 20% and smaller than 40%, and an area reduction ratio of the die from the wire diameter of 1/2 to the final wire diameter falls within a range equal to or larger than 10% and smaller than 25%. Herein, defining that the area reduction ratio of the wire per die is P1, P1 is represented by the following expression.$P 1 = \left\{\left({{R}_{2}}^{2}-{{R}_{1}}^{2}\right)/{{R}_{2}}^{2}\right\} \times 100$ In the expression, R₂ represents a diameter (mm) of the wire before processing, and R₁ represents a diameter (mm) of the wire after processing.

Furthermore, in heat treatment at the final wire diameter or in intermediate heat treatment at a small diameter close to the final wire diameter, a concentration inclination of voids in the surface region is assisted by improving lubricity in an aqueous solution for the wire-drawing processing and accelerating deformation in which a surface is elongated in a wire-drawing direction. It is preferable to select, as a lubricating liquid to be used, a water-based liquid containing a surfactant or the like that reduces a friction coefficient.

Performing intermediate heat treatment, which is performed in the middle of the wire-drawing processing, in an atmosphere of an inert gas such as an N₂ gas is also effective for controlling a concentration inclination of voids. By controlling oxidation of Si in Al during wire-drawing, it is possible to assist maintaining Si at a low concentration in the vicinity of the surface, and eventually it is possible to reduce the void volume fraction in the vicinity of the surface.

### <Control of small-diameter ratio of Si phase>

Optimizing an intermediate heat treatment condition and a final heat treatment condition as a set is effective for controlling the small-diameter ratio of the Si phase. Specifically, when a temperature of the intermediate heat treatment at a wire diameter (final) closest to the final wire diameter is defined as Tm (°C) and a temperature of the final heat treatment at the final wire diameter is defined as Tc (°C), if the temperature Tm of the intermediate heat treatment is higher than the temperature Tc of the final heat treatment by 50°C or more, it becomes easy to adjust the small-diameter ratio of the Si phase to be equal to or larger than 30% and equal to or smaller than 95%. Specifically, by increasing the intermediate heat treatment temperature, Si dissolved in the Al phase as a solid solution can be homogenized, and by decreasing the temperature of the final heat treatment step, a solid-solution concentration of Si in the Al phase can be reduced. By a combination of these temperatures, the number of minute Si phases can be increased, and the small-diameter ratio of the Si phase can be increased. Among a plurality of intermediate heat treatments, adjusting the temperature of the last intermediate heat treatment is more effective, and it is considered that increasing the number of minute Si phases can be promoted by utilizing dislocations and the like increased at a subsequent processing step.

As the final heat treatment condition, it is effective to adjust a temperature range to be equal to or higher than 200°C and lower than 360°C, and adjust a time within a range equal to or longer than 2 hours and shorter than 20 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment, the small-diameter ratio of the Si phase can be easily controlled. For example, by adjusting the final heat treatment to be performed at a low temperature or in a short time, the small-diameter ratio of the Si phase tends to increase.

As a representative example of the Al bonding wire or the Al bonding ribbon, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

### [Semiconductor device]

The semiconductor device can be manufactured by connecting the electrode on the semiconductor chip to the lead frame or an external electrode on the substrate by using the Al bonding wire or the Al bonding ribbon according to the present invention. That is, the semiconductor device according to the present invention includes the Al bonding wire or the Al bonding ribbon according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention includes a circuit board, the semiconductor chip, and the Al bonding wire or the Al bonding ribbon for bringing the circuit board and the semiconductor chip into conduction with each other, and is characterized in that the Al bonding wire or the Al bonding ribbon is the Al bonding wire or the Al bonding ribbon according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

### [Examples]

Hereinafter, the present invention will be described in detail with reference to Examples. However, the present invention is not limited to the following Examples.

### (Sample)

A method for producing a sample will be described. As a raw material, Al having a purity of 4N (99.99% by mass or more) and including inevitable impurities as a balance was used. Si, the first element group (Sr, Na, Eu, P), the second element group (Ni, Ti, Fe, Mg), and the other elements (Mn, Zn) used as alloy elements each having a purity of 99.99% by mass or more and including inevitable impurities as a balance were also used. The Al alloy used for the Al bonding wire or the Al bonding ribbon was manufactured by loading an Al raw material and raw materials for the alloy elements into a melting crucible, and manufacturing a casting using a continuous casting furnace. An atmosphere inside the furnace at the time of melting was an Ar atmosphere, and the highest end-point temperature of melted metal at the time of melting was set to be equal to or higher than 800°C and lower than 1050°C. The cooling method after the melting was air cooling for performing cooling in the air, or water cooling for performing cooling in water.

After an ingot of Φ6 mm having a cylindrical shape was obtained by melting, and the ingot was subjected to solution treatment and homogenization processing, wire-drawing processing using dies and intermediate heat treatment were performed to produce an Al bonding wire of Φ300 µm. By using the Al bonding wire of Φ300 µm as a starting material, an Al bonding ribbon having a thickness of 100 µm and a width of 600 µm was manufactured by two-stage rolling. A temperature range for the solution treatment was set to be equal to or higher than 500°C and lower than 550°C, and a time therefor was set to be equal to or longer than 2 hours and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 2 hours and shorter than 5 hours. The cooling method after the homogenization processing was air cooling for performing cooling in the air.

The intermediate heat treatment was performed three to four times. Regarding the wire diameter after the intermediate heat treatment relative to the final wire diameter, first intermediate annealing was performed at a wire diameter in a range from 6.5 to 7.0 times, second intermediate annealing was performed at a wire diameter in a range from 4.0 to 5.0 times, and third intermediate annealing was performed at a wire diameter in a range from 2.0 to 3.0 times. In a case in which the intermediate heat treatment was performed four times, the first intermediate annealing was performed at a wire diameter in a range from 7.5 to 8.5 times the final wire diameter. A temperature range for the intermediate heat treatment was adjusted set such that, for the first and second intermediate heat treatments, a temperature was equal to or higher than 300°C and lower than 370°C and a time was equal to or longer than 1 hour and shorter than 3 hours, and for the third and fourth intermediate heat treatments, the temperature was equal to or higher than 250°C and lower than 400°C and the time was equal to or longer than 2 hours and shorter than 40 hours, respectively.

A commercially available lubricating liquid was used at the time of the wire-drawing processing, and an area reduction ratio of the wire per die at the time of the wire-drawing processing was equal to or larger than 10.0% and smaller than 30.0%. The area reduction ratio of the wire was adjusted in accordance with a wire diameter of the die. A temperature range for the final heat treatment was set to be equal to or higher than 200°C and lower than 350°C, and a time for the final heat treatment was set to be equal to or longer than 2 hours and shorter than 20 hours. The temperature (Tc) for the final heat treatment was selected in a temperature range 50 to 100°C lower than the temperature (Tm) of the third or the fourth intermediate annealing described above.

In some examples, the wire-drawing processing was performed using a die having a die angle equal to or larger than 14° and smaller than 18°.

### (Method for measuring element content)

For concentration analysis of elements contained in the Al bonding wire or the Al bonding ribbon, Inductively Coupled Plasma-Optical Emission Spectrometer (ICP-OES) ("PS3520UVDDII" manufactured by Hitachi High-Tech Science Corporation) or Inductively Coupled Plasma-Mass Spectrometer (ICP-MS) ("Agilent 7700x ICP-MS" manufactured by Agilent Technologies, Inc.) was used as an analysis apparatus.

### (X-ray CT analysis)

As an apparatus, a 3D X-ray microscope "Xradia 520 Versa" (manufactured by ZEISS) was used. An X-ray voltage was 40 kV, an X-ray output was 3 W, a wavelength limiting filter was LE1, and a magnification lens was 4x. As a result of using the conditions described above, a transmission image having a transmittance of 30% to 70% was obtained. To observe minute voids, by setting a size per pixel to be about 0.7 µm/pixel, a region of about 700 µm × 700 µm × 700 µm was measured as a measurement field of view. By fixing an end of the sample with a sample length of about 10 mm, a CT projection image was measured by transmitting X-rays at a rotation angle of 360 degrees about an axis of the sample. In this measurement, CT projection images were acquired at intervals of 0.225°/image with respect to the rotation angle of 360° (1601 images in total). Furthermore, observation was performed with an exposure time of 30 seconds per CT projection image. After CT projection images at all angles were obtained, reconstruction processing such as center shift processing was performed, whereby three-dimensional image data was acquired. In addition, beam hardening processing was performed as needed.

Next, the three-dimensional image data was analyzed by using image analysis software. As the image analysis software, Avizo Inspection was used. The three-dimensional image data reflects a density difference in an observation region as a three-dimensional distribution of luminance values. A relatively high-density wire or ribbon region (substance) has high luminance, and a low-density void or outer space has low luminance. First, a luminance histogram (FIG. 3) was created by using measurement data obtained by graphing a luminance value in each voxel of the three-dimensional image data and a frequency thereof. A luminance value at a midpoint between two peak positions corresponding to a void or an outer space and a substance was set as a threshold. An image data region showing a luminance lower than the threshold was identified as a void or an outer space (an environment around the sample). Next, with respect to the identified void and outer space, processing of selecting a region of the outer space and removing the region from the image data region was performed. Due to this, image data of only voids in the substance within the measurement region of the sample can be identified. Next, by similar processing, image data having a luminance higher than the threshold was identified as image data relating to the substance.

Analysis was performed on respective pieces of image data of the voids and the substance obtained as described above. The following specifically describes a method for calculating the void inclination ratio. By using the image analysis software, the total volume Vs of voids having an equivalent sphere diameter equal to or larger than 1 µm and smaller than 10 µm and the volume (Vm) of the substance were calculated. A ratio (Vk/(Vk + Vg)) obtained by dividing Vk by a total volume (Vk + Vg) of the substance and the voids having an equivalent sphere diameter equal to or larger than 1 µm and smaller than 10 µm was calculated as the void volume fraction. According to this method, the volume fractions Rd and Rf of voids in the core part and the surface part, respectively, were calculated, and the void inclination ratio (Rf/Rd) was calculated.

### (Small-diameter ratio [Ns/Nc × 100 (%)] of Si phase)

In measuring the small-diameter ratio [Ns/Nc × 100 (%)] of the Si phase in the L cross-section, the SEM-EDS-EBSD apparatus was used, and a method of combining information of Al concentration and Si concentration obtained by the SEM-EDS and information of a crystal orientation obtained by the EBSD was used. Specifically, measurement was performed in accordance with procedures from (1) to (3) as follows.
(1) In the measurement region designating the L cross-section of the Al bonding wire or the Al bonding ribbon to be the inspection surface, measurement of concentration of Al and Si using the EDS and crystal orientation measurement using the EBSD were performed at the same time.
(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si in the material file was used for analyzing the crystal orientation. Herein, a condition for Tolerance was mainly set to be 30%, and adjusted as needed.
(3) For the region that is specified as the Si phase, the crystal orientation was analyzed, and if the orientation difference between measurement points was equal to or larger than 15°, it was determined to be the crystal grain boundary, and the equivalent circle diameter of each crystal grain was obtained. The number of crystal grains identified as the Si phase was counted, and the total number Nc of particles of the Si phase was obtained. Herein, the Si phase having an equivalent circle diameter equal to or larger than 0.5 µm was targeted. In consideration of analysis accuracy of current analysis apparatuses of EDS and EBSD, fine ones smaller than 0.5 µm were excluded from the target. Subsequently, the number Ns of the Si phases having an equivalent circle diameter in a range equal to or larger than 0.5 µm and equal to or smaller than 0.8 µm was counted. The ratio of Ns to Nc [Ns/Nc × 100 (%)] (small-diameter ratio of the Si phase) was then calculated.

The small-diameter ratio of the Si phase was calculated as an average value (arithmetic mean) of respective values obtained for measurement regions at three parts through the procedures from (1) to (3) described above.

### (Method for evaluating Al bonding wire or Al bonding ribbon)

The following describes a method for evaluating the Al bonding wire. The wire diameter of the Al bonding wire used for evaluation was Φ300 µm. The semiconductor chip made of Si was used, and as the electrode on the semiconductor chip, used was an alloy having a composition of Al-0.5%Cu deposited to have a thickness of 4 µm. As a substrate, 5 µm of Ni was deposited on an Al alloy. For bonding of the Al bonding wire, a commercially available wire bonder (manufactured by ULTRASONIC ENGINEERING CO., LTD.) was used, and wedge bonding was used for both of the 1st bonding (bonding with the electrode described above on the semiconductor chip) and the 2nd bonding (bonding with the substrate described above). For bonding of the Al bonding ribbon, a fully automatic bonder "BJ955" that is manufactured by Hesse GmbH and equipped with a ribbon bond head was used.

### (Method for evaluating rapid temperature cycle reliability)

For the rapid temperature cycle test (rapid TCT), a commercially available rapid-rate thermal shock test apparatus was used. In the rapid TCT, hot air is blown to a sample to perform rapid heating. A sample to be subjected to the rapid TCT had a structure in which a semiconductor chip was mounted on a substrate, and an electrode on the semiconductor chip was connected with an electrode on the substrate via the Al bonding wire or the Al bonding ribbon. Heating and cooling were performed as one cycle to repeatedly apply a thermal load to the sample placed in a sample chamber of the rapid-rate thermal shock test apparatus. A minimum temperature at the time of cooling was -40°C, and a maximum temperature at the time of heating was 185°C. A heating time including a temperature rising time was 20 seconds, and a cooling time including a temperature falling time was 40 seconds. After the test was started, the sample was taken out after 10,000 cycles, and a shear force test was performed on the 1st bonding part. As a value of shear force (shear force) of the 1st bonding part used for evaluating the rapid temperature cycle reliability, an average value of shear force of 1st bonding parts at ten points, which were randomly extracted, was used. A ratio (percentage) of average shear force after performing the rapid TCT to average shear force before the test was defined to be a force retention rate. As the force retention rate is higher, reliability of the bonding part is more excellent. If the force retention rate was equal to or larger than 70%, it was determined to be excellent and the value was determined to be "3". If the force retention rate was equal to or larger than 60% and smaller than 70%, it was determined to be excellent and the value was determined to be "2". If the force retention rate was equal to or larger than 50% and smaller than 60%, it was determined that improvement was required and the value was determined to be "1". If the force retention rate was smaller than 50%, it was determined that a problem was caused in a practical use and the value was determined to be "0". It was determined that "3" and "2" were acceptable, and "1" and "0" were unacceptable. Evaluation results are described in a column of "Rapid temperature cycle reliability 10,000 cycles" in tables.

### (Evaluation of rapid temperature cycle reliability for 13,000 cycles)

In the rapid temperature cycle test described above, a lower limit temperature was set to -40°C and an upper limit temperature was set to 185°C, and the test was performed up to 13,000 cycles. A shear test was performed on the 1st bonding part. As a value of shear force of the 1st bonding part used for evaluating the rapid temperature cycle reliability, an average value of shear force of 1st bonding parts at five points, which were randomly extracted, was obtained. A bonding strength retention ratio, which is a ratio of shear force after the temperature cycle test to a value before the test, was evaluated. If the bonding strength retention ratio was smaller than 50%, it was determined that there was a problem in a practical use and evaluated as "0". If the bonding strength retention ratio was equal to or larger than 50% and smaller than 60%, it was determined that improvement was required and evaluated as "1". If the bonding strength retention ratio was equal to or larger than 60% and smaller than 70%, it was determined to be excellent and evaluated as "2". If the bonding strength retention ratio was equal to or larger than 70%, it was determined to be especially excellent and evaluated as "3". Evaluation results are described in a column of "Rapid temperature cycle reliability 13,000 cycles" in the tables.

### (Method for evaluating shear force ratio of 1st bonding part)

The following describes a method for evaluating the shear force ratio of the 1st bonding part. Regarding bonding conditions, with reference to standard conditions for the Al bonding wire, an ultrasonic output and load were set to be slightly higher to secure a bonding area. The shear force was evaluated by a shear test for measuring the shear force of the 1st bonding part. The 1st bonding was performed at ten parts and the shear test for the 1st bonding part was performed to measure an average value (SH) of the shear force. For measurement of the shear force, a commercially available micro shear force tester (4000-PLUS manufactured by Nordson Corporation) was used. A shear rate was set to be 200 µm/sec, and a height of a shearing tool was set to be 10 µm from an electrode surface. The shear force was measured by fixing, with a jig, a substrate to which the Al bonding wire or the Al bonding ribbon was bonded. Furthermore, a tensile test was performed on five samples, and an average value (PS) of 0.2% proof stress was measured. As a tensile testing machine, "RTF-1225" (manufactured by A&D Company, Limited) was used, and a tensile speed was set to 10 mm/min. A ratio obtained by dividing the shear force (SH) by the 0.2% proof stress (PS) in the tensile test (SH/PS) was used as the shear force ratio. If the shear force ratio was equal to or larger than 5.2, it was determined that a bonding state was excellent and evaluated as "3". If the shear force ratio was equal to or larger than 4.5 and smaller than 5.2, it was determined that there was no problem in a practical use and evaluated as "2". If the shear force ratio was equal to or larger than 3.5 and smaller than 4.5, it was determined that improvement was required and evaluated as "1". If the shear force ratio was smaller than 3.5, it was determined that there was a problem in a practical use and evaluated as "0". Evaluation results are described in a column of "Shear force ratio" in the tables.

### (Method for evaluating wire breakage during processing)

The following describes a method for evaluating wire breakage during processing. Wire-drawing processing was performed from a wire diameter of 6 mmφ to a wire diameter of 0.3 mmφ, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al bonding wire fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

### (Method for evaluating scratch and scrape on surface)

A surface property of the Al bonding wire or the Al bonding ribbon was evaluated focusing on scratches and scrapes. The wire diameter of the Al bonding wire was 0.3 mmφ. A thickness of the Al bonding ribbon was 100 µm, and a width thereof was 600 µm. Measurement regions at three parts were randomly selected at intervals of 1 m or more with respect to the center axis direction of the Al bonding wire or the Al bonding ribbon, and three samples each having a length of about 2 cm were taken at each of the three parts to observe nine samples in total. The surface was observed with magnification in a range from 50-fold to 500-fold using the SEM. A scratch having a length equal to or larger than 50 µm or a scrape having a length equal to or larger than 30 µm were determined to be defects. Parts of scratches and scrapes were counted. If the number thereof was 0, it was determined to be favorable and acceptable, and evaluated as "3". If the number thereof was equal to or larger than 1 and equal to or smaller than 2, it was determined that there was no problem in a practical use and evaluated as "2". If the number thereof was 3 to 7, it was determined that the surface property was not good, and evaluated as "1". If the number thereof was equal to or larger than 8, it was determined that a practical use was difficult to be achieved and evaluated as "0". Evaluation results are described in a column of "Surface property" in the tables.

The evaluation results of Examples and Comparative Examples are indicated in Table 1 to Table 4. Examples 1 to 30 and Comparative Examples 1 to 6 in Table 1 to Table 3 are results related to the Al bonding wire, and Examples B1 to B3 and Comparative Example B1 in Table 4 are results related to the Al bonding ribbon.

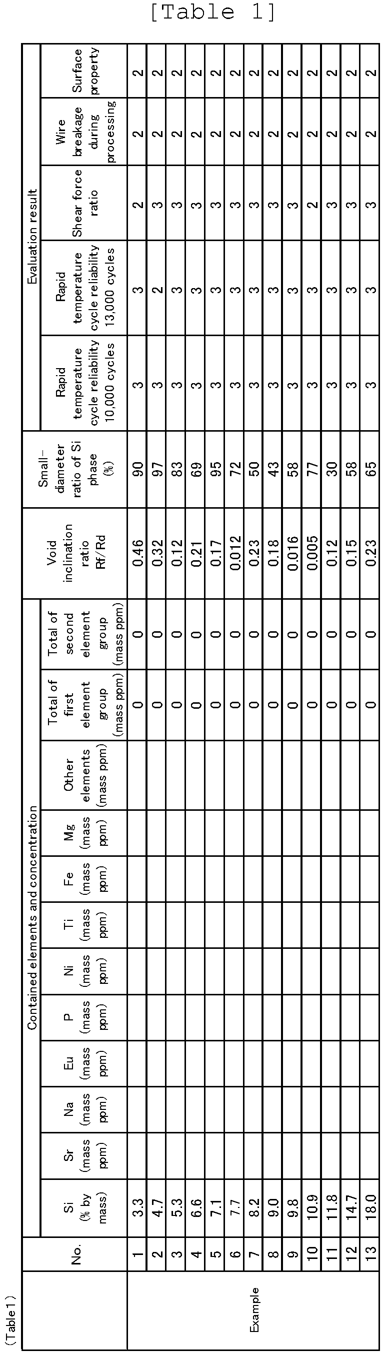

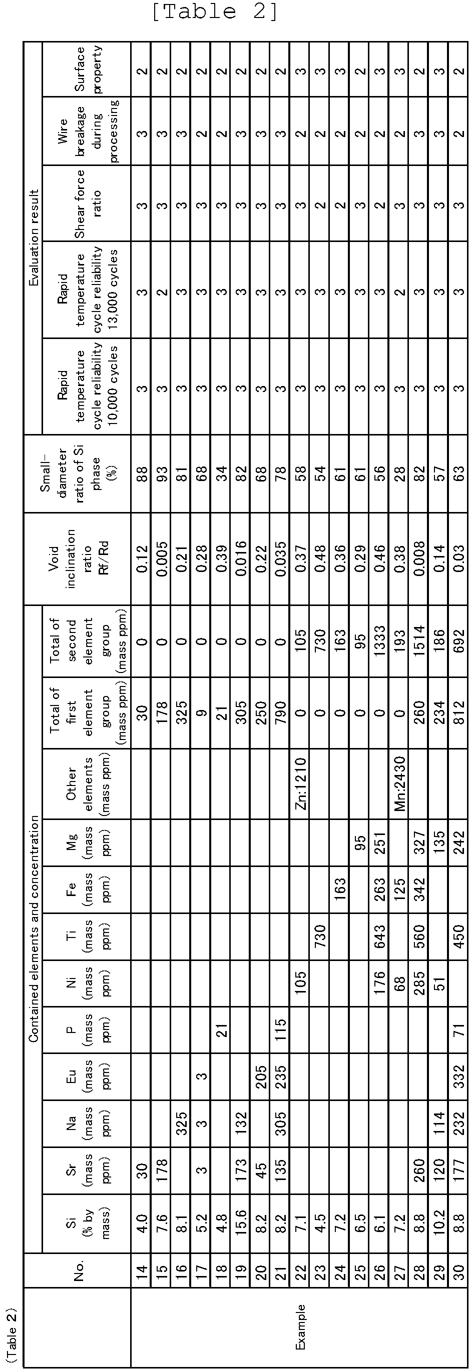

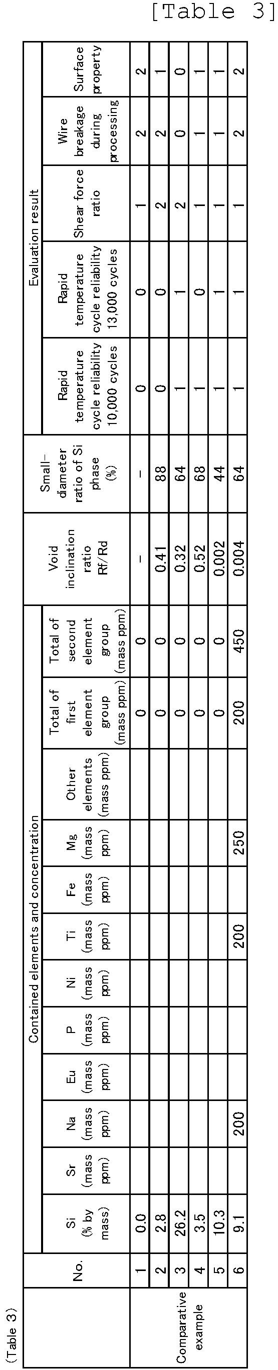

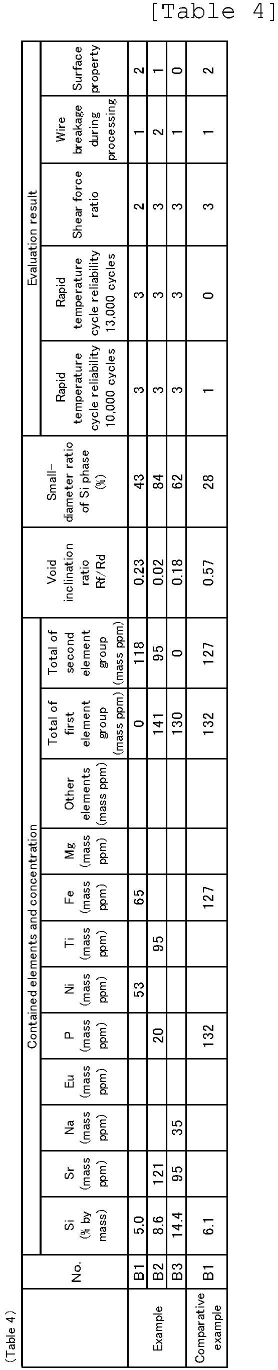

### Reference Signs List

- 1: Al bonding wire
- 10: center axis
- 11: L cross-section
- 2: Al bonding ribbon
- 20: center axis
- 21: L cross-section
- 51: surface part of Al bonding wire
- 52: intermediate part of Al bonding wire
- 53: core part of Al bonding wire
- 61: surface part of Al bonding ribbon
- 62: intermediate part of Al bonding ribbon
- 63: core part of Al bonding ribbon

## Claims

1. An Al bonding wire or an Al bonding ribbon containing 3.0% by mass or more and 20.0% by mass or less of Si, wherein
a closed curve representing an outer periphery of a cross section in a direction perpendicular to a center axis of the Al bonding wire or the Al bonding ribbon is defined as S₀, a closed curve having a similar shape scaled by 2/3 with respect to S₀ is defined as S₁, and a closed curve having a similar shape scaled by 1/3 with respect to S₀ is defined as S₂, and S₀, S₁, and S₂ are arranged such that centroids thereof coincide with a centroid of the cross section in a direction perpendicular to the center axis of the Al bonding wire or the Al bonding ribbon, and a region surrounded by S₀ and S₁ is defined as a surface part and a region surrounded by S₂ is defined as a core part, and
when a volume fraction of voids having an equivalent sphere diameter equal to or larger than 1 µm and smaller than 10 µm in the core part measured by X-ray Computed Topograpy (CT) analysis is defined as Rd and a volume fraction of voids having an equivalent sphere diameter equal to or larger than 1 µm and smaller than 10 µm in the surface part is defined as Rf, a ratio (Rf/Rd) is equal to or larger than 0.005 and equal to or smaller than 0.50.

2. The Al bonding wire or the Al bonding ribbon according to claim 1, wherein, when the number of the Si phases having an equivalent circle diameter equal to or larger than 0.5 µm and equal to or smaller than 0.8 µm in an L cross-section (cross section in a center axis direction including the center axis) is defined as Ns, and the number of the Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.

3. The Al bonding wire or the Al bonding ribbon according to claim 1 or 2, further containing 10 mass ppm or more and 800 mass ppm or less of one or more of Sr, Na, Eu, and P in total.

4. The Al bonding wire or the Al bonding ribbon according to any one of claims 1 to 3, further containing 100 mass ppm or more and 1500 mass ppm or less of one or more of Ni, Ti, Fe, and Mg in total.

5. The Al bonding wire or the Al bonding ribbon according to any one of claims 1 to 4, wherein a total concentration of elements other than Al, Si, Sr, Na, Eu, P, Ni, Ti, Fe, and Mg in the Al bonding wire or the Al bonding ribbon is equal to or smaller than 0.5 % by mass.

6. The Al bonding wire or the Al bonding ribbon according to any one of claims 2 to 5, wherein an equivalent circle diameter of the Si phase and the number of the Si phases are values measured by using an SEM-EDS-EBSD apparatus.

7. The Al bonding wire or the Al bonding ribbon according to any one of claims 1 to 6, used for a semiconductor device.

8. A semiconductor device comprising the Al bonding wire or the Al bonding ribbon according to any one of claims 1 to 7.
